(19) Europäisches Patentamt
European Patent Office
Office européen des brevets

(11) **EP 4 768 461 A1**

(12) **EUROPEAN PATENT APPLICATION**
published in accordance with Art. 153(4) EPC

(43) Date of publication:
**01.07.2026 Bulletin 2026/27**

(21) Application number: **24859049.9**

(22) Date of filing: **13.05.2024**

(51) International Patent Classification (IPC):
*C04B 35/80* (2006.01)     *C23C 16/42* (2006.01)

(52) Cooperative Patent Classification (CPC):
**C04B 35/565; C04B 35/62873; C04B 35/62884;
C04B 35/80; C23C 16/42;** C04B 2235/5244;
C04B 2235/5248; C04B 2235/614

(86) International application number:
**PCT/JP2024/017572**

(87) International publication number:
**WO 2025/047000 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.08.2023 JP 2023137581**

(71) Applicants:
• **IHI Corporation
Tokyo 135-8710 (JP)**
• **The University of Tokyo
Bunkyo-ku, Tokyo 113-8654 (JP)**

(72) Inventors:
• **FUKUSHIMA, Yasuyuki
Tokyo 135-8710 (JP)**
• **SHIMOGAKI, Yukihiro
Tokyo 113-8654 (JP)**
• **MOMOSE, Takeshi
Tokyo 113-8654 (JP)**
• **SATO, Noboru
Tokyo 113-8654 (JP)**
• **OTAKA, Yuhei
Tokyo 113-8654 (JP)**
• **KIMURA, Shunsuke
Tokyo 113-8654 (JP)**

(74) Representative: **MERH-IP Matias Erny Reichl
Hoffmann
Patentanwälte PartG mbB
Paul-Heyse-Straße 29
80336 München (DE)**

(54) **METHOD FOR PRODUCING FIBER-REINFORCED COMPOSITE MATERIAL**

(57) A method for producing a fiber-reinforced composite, is provided with: introducing a reinforcing fiber fabric into an atmosphere-controllable reaction furnace, the reinforcing fiber fabric including reinforcing fibers woven together and gaps having aspect ratios of 35 or larger between the reinforcing fibers; flowing into the reaction furnace a source gas including hydrogen and methyltrichlorosilane; and causing a reaction to create a coating of silicon carbide within the gaps by heating the reaction furnace to maintain the reinforcing fiber fabric at a temperature above 1000 degrees C and below 1100 degrees C with maintaining the reaction furnace at a pressure below an atmospheric pressure, whereby the coating binds the reinforcing fibers together.

FIG. 4

**Description**

**TECHNICAL FIELD**

The present disclosure relates to a method in which vapor phase synthesis is used to form a matrix in narrow gaps between reinforcing fibers to produce a fiber-reinforced composite.

**BACKGROUND ART**

Although ceramics offer advantages such as high strength and heat resistance, many kinds of ceramics have the drawback of brittleness. In order to overcome the brittleness, attempts have been made to combine ceramics as matrices with reinforcing fibers made of inorganic substances such as SiC. For example, it is possible to produce a fiber-reinforced composite by weaving reinforcing fiber bundles, in each of which several hundreds of reinforcing fibers are bundled together, into a fabric, and using a chemical vapor infiltration (CVI) method to fill a ceramic into gaps between the reinforcing fibers in the fabric.

The CVI method is expected to successfully form a matrix in narrower gaps as compared with any other methods, such as liquid phase infiltration (for example, polymer melt infiltration and pyrolysis: PIP), solid phase infiltration (SPI), and melt infiltration (MI). A production process only by the CVI method is, however, not sufficiently productive because growth of the matrix by this method is particularly slower than those by the other methods. Some attempts have been made, one of which is to apply the CVI method to very narrow gaps and any other method to wider gaps.

The patent literatures 1, 2 disclose related arts.

Citation List

Patent Literature

   PTL 1: PCT International Publication WO 98/21163 Al
   PTL 2: PCT International Publication WO 2015/129772 Al

**SUMMARY OF THE INVENTION**

In order to increase the growth rate by the CVI method, various parameters have been investigated and efforts have been made to improve reaction chambers. Although these efforts have yielded some success, resultantly the advantages of the CVI method might be limited if the improvements were traded off for insufficient infiltration into narrow gaps. The art disclosed hereinafter was created in order to overcome these problems.

According to the present disclosure, a method for producing a fiber-reinforced composite, is provided with: introducing a reinforcing fiber fabric into an atmosphere-controllable reaction furnace, the reinforcing fiber fabric including reinforcing fibers woven together and gaps having aspect ratios of 35 or larger between the reinforcing fibers; flowing into the reaction furnace a source gas including hydrogen and methyltrichlorosilane; and causing a reaction to create a coating of silicon carbide within the gaps by heating the reaction furnace to maintain the reinforcing fiber fabric at a temperature above 1000 degrees C and below 1100 degrees C with maintaining the reaction furnace at a pressure below an atmospheric pressure, whereby the coating binds the reinforcing fibers together.

**EFFECTS OF THE INVENTION**

A method is provided, which is capable of forming a matrix of silicon carbide even in relatively narrow gaps with high efficiency.

**BRIEF DESCRIPTION OF THE DRAWINGS**

   FIG. 1 is a schematic perspective view of a reinforcing fiber bundle in which multiple reinforcing fibers are bundled together.
   FIG. 2 is a schematic perspective view of a fabric formed of reinforcing fiber bundles.
   FIG. 3 is a drawing schematically showing a device for vapor phase synthesis to produce a fiber-reinforced composite.

FIG. 4 is a schematic sectional view of a substrate with a gap and a coating formed in the gap.

FIG. 5 is a SEM image obtained by forming a silicon carbide coating in a gap at 1050 degrees C and observing its section.

FIG. 6 is a SEM image obtained by forming a silicon carbide coating in a gap at 1075 degrees C and observing its section.

FIG. 7 is a SEM image obtained by forming a silicon carbide coating in a gap at 1100 degrees C and observing its section.

FIG. 8 is a graph showing dependence of a growth rate on temperature.

FIG. 9 is a graph showing dependence of growth rates, as broken down by film growth species, on temperature.

FIG. 10 is a graph showing dependence of the ratio in a growth rate on temperature.

## DESCRIPTION OF EMBODIMENTS

Certain embodiments will be described hereinafter with reference to the appended drawings.

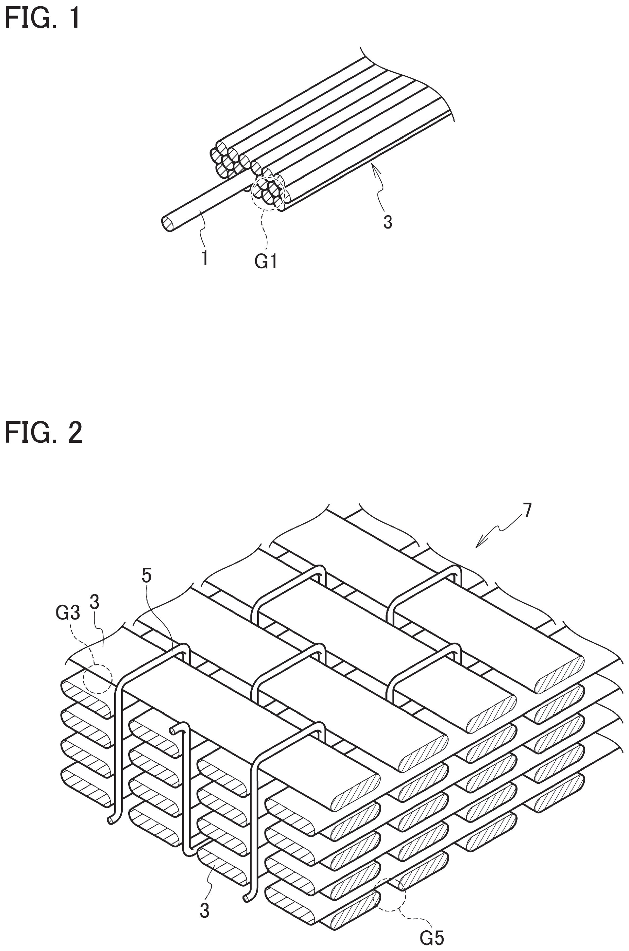

Referring to FIG. 1, a reinforcing fiber 1 is, for example, a long filament with a diameter of from several to several tens micrometers and formed of any inorganic substance such as silicon carbide. In general, several hundreds of reinforcing fibers 1 are bundled together by a proper sizing agent to constitute a fiber bundle 3. In place of, or in addition to, the sizing agent, any other proper fibers may be wound around and thereby bind the plural fibers to form the fiber bundle. Plural fiber bundles 3 are, as illustrated in FIG. 2, arranged vertically and horizontally and interwoven to form a reinforcing fiber fabric 7. Although in the example shown in FIG. 2 the fiber bundles 3 are stacked while remaining generally straight and then tied together by distinct fibers or fiber bundles 5 running in directions penetrating the stack, the fiber bundles 3 itself may instead meander and interwoven together. Although one fiber bundle 3 runs in parallel with or perpendicular to another fiber bundle 3 in the example, of course the bundles may cross each other diagonally. The fabric 7 may be a two-dimensional fabric not shown but may be a three-dimensional fabric as illustrated in FIG. 2. The fabric 7 is, after being cut and shaped into a proper form, made into a preform 100 and subjected to a matrix formation process as described later.

As will be readily understood from FIGs. 1 and 2, the fabric 7 contains various gaps. For instance, a gap G1 between adjacent fibers 1 in each fiber bundle 3 is very narrow in width, for example on the order of 1 micrometer for example. The length of the gap G1, on the other hand, is very long as compared with its width, for example up to several mm or longer. In sum, the aspect ratio of the gap G1 may be over 1000. A gap G3 between fiber bundles 3 is, however, on the order of 10 micrometers and therefore the aspect ratio may be on the order of several tens or several hundreds. A gap G5 held at a part where fiber bundles 3 are not in contact with each other is still larger in width and therefore its aspect ratio can be still smaller. Although details will be described later, the production method according to the present embodiment can be used to form matrices in any of these gaps but may be preferably applied to matrix formation in gaps having relatively large aspect ratios. More specifically, while it is difficult to grow a matrix on or around a bottom of the gap in a form such as the gap G3 because its aspect ratio is relatively large, a sufficiently large growth rate is required to fill the gap with the matrix because the width is relatively large. The present embodiment is particularly preferably applied to these gaps, whereas of course it is additionally preferably applied to gaps such as the gap G1.

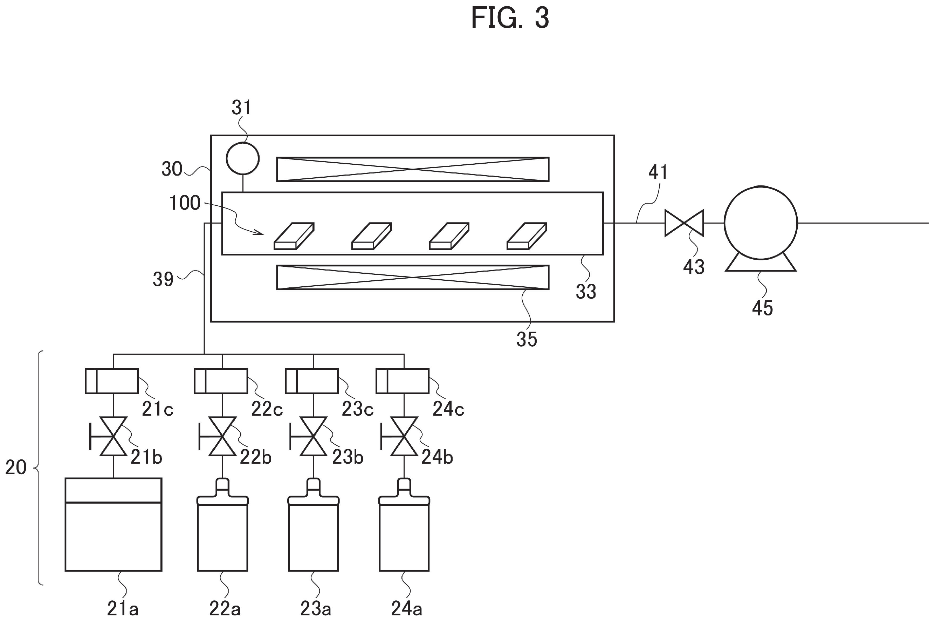

Referring to FIG. 3, a production device for a fiber-reinforced composite according to the present embodiment is generally provided with a feeder system 20 for feeding a source gas, and a reaction furnace 30 for carrying out vapor phase reactions with controlling the atmosphere. Through a flow path 39, a source gas is fed from the feeder system 20 to the reaction furnace 30 and in turn the reaction furnace 30 exhausts post-reaction gases through an exhaust duct 41.

The feeder system 20 includes a source gas feeder system and two or more sub-source gas feeder systems. The source gas feeder system is to feed a main source such as methyltrichlorosilane (MTS), and may include a tank 21a, a valve 21b, and a mass flow controller 21c for example. MTS is stored in the tank 21a in the liquid state, and, at room temperature or by being properly heated, gradually evaporates. Vaporized MTS passes through the valve 21b and the mass flow controller 21c and is thereby, at a controlled flow rate, delivered to a reaction chamber 33. The sub-source gas feeder systems are used to feed sub-sources or a carrier gas such as hydrogen, hydrogen chloride, and helium, which are respectively compressed and stored in cylinders 22a, 23a, 24a and are fed to the reaction chamber 33 through valves 22b, 23b, 24b and mass flow controllers 22c, 23c, 24c. The composition of fed gases can be of course regulated by properly regulating these devices.

The furnace 30 is, in the interior, provided with the reaction chamber 33 for accommodating the preform 100 and a heater along the chamber. The reaction chamber 33 is for example, but not limited to, of a quartz tube having open ends. The reaction chamber 33 may be elongated enough in the direction of the gas flow, and therefore capable of accommodating a plurality of preforms 100 simultaneously. These preforms 100 may be loaded in and out in batches, or it is instead possible to apply a continuous production method in which multiple preforms are transported and processed sequentially from the entrance to the exit. The heater 35 is a proper heating device such as a carbon heater, which projects heat through the wall of the reaction chamber to the interior gas flow and the preforms 100 and controls the temperature of them. For the purpose of temperature measurement, the furnace 30 may include a thermocouple or other thermometer. Of course, on the basis of the output of the thermometer, feedback control may be applied to the heater 35.

The exhaust duct 41 is connected to a pump 45 and balance between the supply from the feeding system 20 and the exhaust by the pump 45 can be used for pressure regulation in the reaction furnace 30. To check the pressure, a vacuum gauge 31 is applicable and also, on the basis of its output, feedback control can be applied to supply and exhaust volumes. To regulate the exhaust capacity and block the reaction furnace 30, a valve 43 may be interposed on the exhaust duct 41.

The preform 100 is loaded in the reaction chamber 33 and is properly fixed there. MTS is premixed with hydrogen, or further mixed with hydrogen chloride, and is further diluted by helium, thereby being fed into the furnace 30 at the regulated flow rate. By the balance between the supply of these gases and the exhaust by the pump 45, the pressure in the furnace 30 is regulated. Usually, throughout the process of the reaction, the furnace is kept below the atmospheric pressure. In parallel, as the gas flow and the preform 100 is heated by the heater 35, MTS is decomposed to cause growth of a coating of silicon carbide on surfaces of the reinforcing fibers 1, or on surfaces of the coating previously sticking to the fibers. The coating fills the gaps G1, G3, G5, thereby becoming a matrix and ultimately binding the reinforcing fibers 1 together.

The reaction conditions are in general, for example, a total pressure of from 5 to 760 Torr, a temperature of from 800 to 1100 degrees C, and a total flow rate of the source/sub-source gases of from 100 to 1000 sccm. The ratio of MTS to hydrogen in the source/sub-source gases is from 0.2 to 3, and the remainder is an inert gas such as helium, or the inert gas and hydrogen chloride.

The growth rate of the coating depends on the total pressure. On average throughout the preform, the growth rate of the coating generally tends to increase with total pressure up to about 50 Torr at least. The growth rate, however, tends to decrease above 80 Torr. These tendencies seem not very dependent on temperature. The growth rate of the coating further depends on the temperature, and tends to increase with temperature up to as low as 850 degrees C and rather decrease over 900 degrees C. More specifically, the total pressure can be preferably 20 Torr or greater and less than the atmospheric pressure, and more preferably 50 Torr or greater and 300 Torr or less, and the temperature can be preferably from 850 to 900 degrees C.

On the other hand, the thicker the preform, the more unlikely it is that the coating grows sufficiently around its center. The growth rate distribution in the thickness direction depends on both total pressure and temperature, and generally, the higher the pressure and the temperature, the greater the difference thereof in the thickness direction. The total pressure and/or the temperature may be thus reduced in accordance with the thickness of the preform. In a case where the preform is particularly thick for example, the total pressure may be 50 Torr or lower and the temperature may be 850 degrees C or lower to prioritize growth uniformity in the thickness direction.

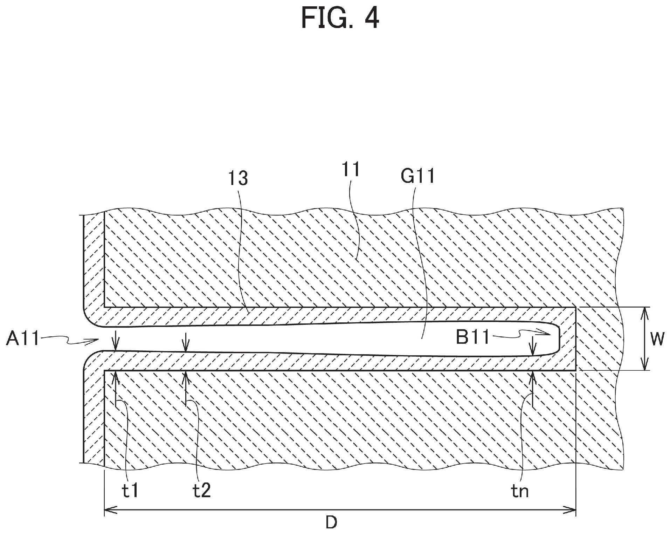

The growth conditions as described above are determined taking into account average coating growth throughout the preform. When considering the growth conditions in micro structures such as gaps in the preform, preferable conditions would be different. MTS is one of film growth species, each of which by itself sticks to reaction surfaces and decomposes there so as to form silicon carbide, but in addition highly reactive intermediates such as radicals derived from MTS are also film growth species. The latter have far larger sticking probabilities than the former. When a film growth species enters through an opening of a gap and sticks to any active sites on surfaces where the coating grows, the highly reactive intermediates, more predominantly over MTS, stick to the active sites around the opening. As a result, as illustrated in FIG. 4, the film growth rate of the coating in general becomes larger around the opening of the gap. More specifically, the greater the contribution of the reactive intermediates, the earlier the area around the opening becomes filled, thereby obstructing matrix formation in the gap. Therefore a balance between the contribution of MTS to the growth and that of the reactive intermediates is important particularly in growth of a coating in gaps having aspect ratios above a certain level.

It can be predicted that the coating formation within the gaps will be less uniform at higher temperatures. Contrary to such a prediction, as will be described later in detail with reference to test results, it is possible to form a matrix in the gaps at temperatures over 1000 degrees C. However, considering the heat resistance of the furnace, the temperature can be limited to 1100 degrees C or less for example. Among the source/sub-source gases, the ratio of MTS to hydrogen is 1 or more, and the total pressure is from 50 to 80 Torr.

The reaction conditions are not required to be consistent throughout the process of forming the matrix, but can be changed as appropriate. For example, in a first step, first reaction conditions suitable for the gap G1 having a larger aspect ratio may be applied, in a second step, second reaction conditions suitable for the gap G3 having a medium aspect ratio may be applied, and in a third step, third reaction conditions suitable for the gap G4 having a small aspect ratio may be applied. Here, in one or more of these multiple steps, the CVI method may be replaced with any other methods. These steps may be carried out as a batch process where these steps are independently executed, or may be carried out as a series of processes with continuously changing conditions.

In order to study the conditions for matrix formation, some tests for forming silicon carbide films were carried out on substrates having gaps as shown in FIG. 4. Each substrate 11 is formed of silicon and has a trench G11 having a width W and a depth D (its aspect ratio is D/W). The trench G11 simulates a gap between fibers. The device shown in FIG. 3 was used to carry out the test for silicon carbide coating growth by introducing plural substrates 11 into the furnace 30. A source gas was flowed into the furnace 30 at a total flow rate of 640 sccm, where a flow rate of MTS was 320 sccm, hydrogen 80 sccm, and helium as the remainders, and its total pressure was regulated to be 60 Torr (partial pressures of MTS and hydrogen were 30 Torr and 7.5 Torr, respectively), and the substrates 11 were heated at from 925 to 1100 degrees C by the heater 35 to form silicon carbide coatings.

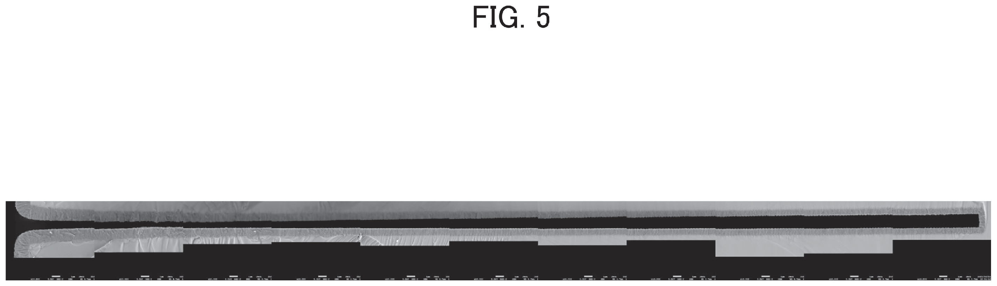

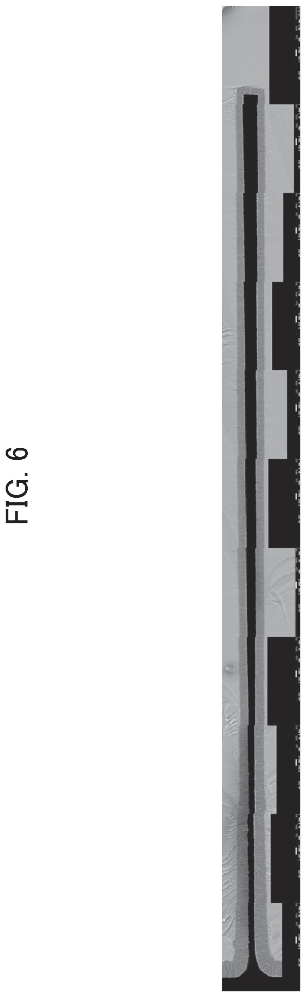

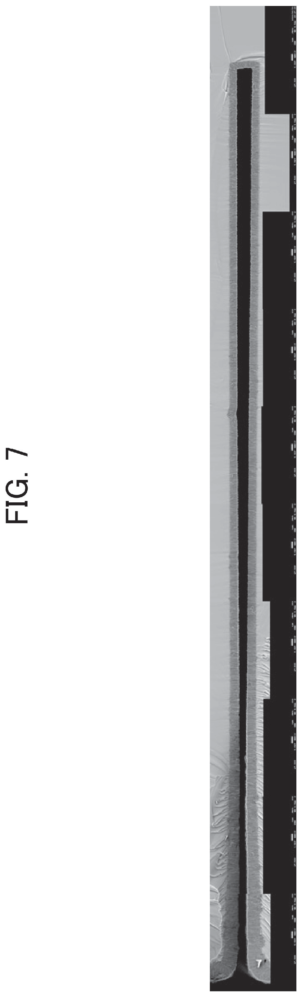

After forming the coatings, the substrates 11 were taken out of the furnace, respectively cut and subject to microscopic observation with a scanning electron microscope (SEM), in which thicknesses t1, t2, ... tn of the coating 13 were measured at regular intervals from the opening All to the bottom B11 of the trench G11. Examples of sectional SEM images are shown in FIG. 5 to 7 and thickness measurement results therefor are listed in Table 1. The aspect ratios of the trenches are 43 in the example shown in FIG. 5 and 35 in the examples shown in FIG. 6 and 7.

**Table 1 Film thickness measurement results**

| (relative thickness if thickness at the opening is 1) | | | | | | | | | | | | |
|---|---|---|---|---|---|---|---|---|---|---|---|---|
| temp. (°C) | $t_1$ | $t_2$ | $t_3$ | $t_4$ | $t_5$ | $t_6$ | $t_7$ | $t_8$ | $t_9$ | $t_{10}$ | $t_{11}$ | $t_{12}$ |
| 1050 | 1.00 | 0.78 | 0.67 | 0.56 | 0.50 | 0.50 | 0.44 | 0.44 | 0.44 | 0.44 | 0.44 | 0.44 |
| 1075 | 1.00 | 0.75 | 0.65 | 0.60 | 0.55 | 0.50 | 0.50 | 0.50 | 0.50 | 0.50 | 0.50 | 0.50 |
| 1100 | 1.00 | 0.76 | 0.65 | 0.59 | 0.53 | 0.47 | 0.47 | 0.47 | 0.47 | 0.47 | 0.47 | 0.47 |

While the film thicknesses are larger around the openings regardless of the temperatures at which the films were grown, the film thicknesses are generally constant at distances of 60 micrometers or more from the openings. Assuming that the film growth is a superposition of growth due to MTS and growth due to highly active species, the contribution of each film growth species was estimated by fitting the following growth rate prediction formula using the sticking probability $\eta$ as a variable.

$$\frac{C}{C_t} = \frac{\cosh\left(\phi\frac{x}{L}\right) + \frac{\phi W}{2L}\sinh\left(\phi\frac{x}{L}\right)}{\cosh\phi + \frac{\phi W}{2L}\sinh\phi},$$

where $\phi = \frac{L}{W}\sqrt{\frac{3}{2}\eta}$

In this equation, $\eta$ is the sticking probability of each firm growth species, $W$ is the width of the opening, and L is the length of the trench.

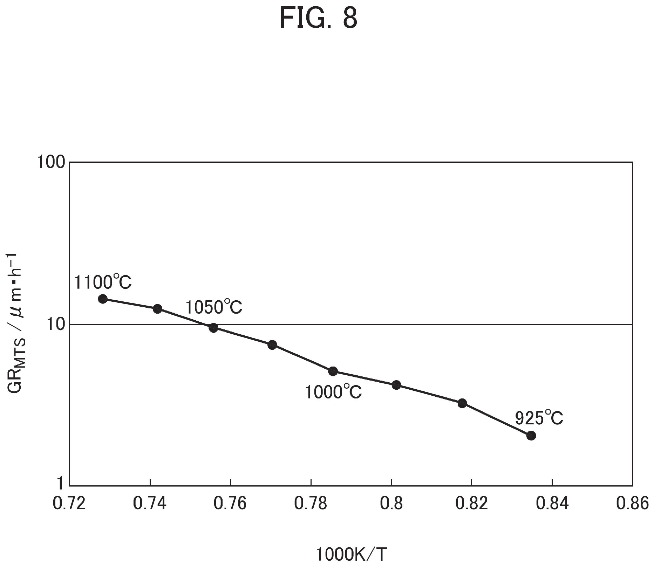

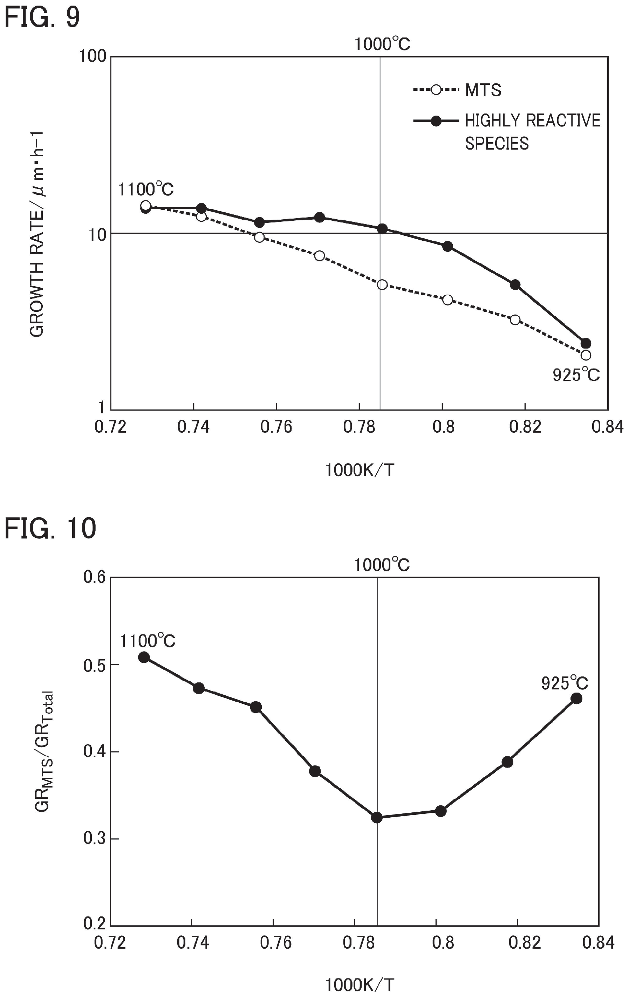

The growth rate due to MTS, as shown in FIG. 8, increases as the temperature rises. While the growth rate due to the highly active species, as shown in FIG. 9, similarly increases as the temperature rises, the growth rate more steeply increases below 1000 degrees C and more gently increases above 1000 degrees C. The ratio of the growth rate due to MTS to the total growth rate is, as understood from FIG. 10, minimal at 1000 degrees C and increases as the temperature rises above 1000 degrees C.

It will be understood from the aforementioned test results that the temperatures at or above 1000 degrees C are advantageous for uniformly growing the coatings in the gaps because the contribution of MTS increases, and are also advantageous in terms of growth rate. These effects are apparently obtained where the aspect ratio of the gap is 35 or larger.

Although there's no test result at temperatures over 1100 degrees C, extrapolating from FIGs. 8-10, it can be predicted that the contribution of MTS further increases, the contribution of the highly active species further decreases, and the total growth rate further increases, and further that uniform growth of the coating is further promoted.

Although certain embodiments have been described above, modifications and variations of the embodiments described above will occur to those skilled in the art, in light of the above teachings.

**INDUSTRIAL APPLICABILITY**

A method is provided, which is capable of forming a matrix of silicon carbide even in relatively narrow gaps with high efficiency.

**Claims**

1. A method for producing a fiber-reinforced composite, comprising:

   introducing a reinforcing fiber fabric into an atmosphere-controllable reaction furnace, the reinforcing fiber fabric including reinforcing fibers woven together and gaps having aspect ratios of 35 or larger between the reinforcing fibers;
   flowing into the reaction furnace a source gas including hydrogen and methyltrichlorosilane; and
   causing a reaction to create a coating of silicon carbide within the gaps by heating the reaction furnace to maintain the reinforcing fiber fabric at a temperature above 1000 degrees C and below 1100 degrees C with maintaining the reaction furnace at a pressure below an atmospheric pressure, whereby the coating binds the reinforcing fibers together.

2. The method of claim 1, wherein a ratio of methyltrichlorosilane to hydrogen in the source gas is 1 or larger.

3. The method of claim 1, wherein, in the step of causing the reaction, an interior of the reaction furnace is kept at 20 Torr or greater and below the atmospheric pressure.

4. The method of claim 1, wherein the step of causing the reaction is continued until the gaps are at least partially filled with the coating.

## FIG. 1

## FIG. 2

FIG. 3

EP 4 768 461 A1

# FIG. 4

FIG. 5

FIG. 6

FIG. 7

# FIG. 8

FIG. 9

FIG. 10

**INTERNATIONAL SEARCH REPORT**

| International application No. |
| --- |
| **PCT/JP2024/017572** |

| A. | CLASSIFICATION OF SUBJECT MATTER |
| --- | --- |

*C04B 35/80*(2006.01)i; *C23C 16/42*(2006.01)i
FI:   C04B35/80 600; C23C16/42

According to International Patent Classification (IPC) or to both national classification and IPC

| B. | FIELDS SEARCHED |
| --- | --- |

Minimum documentation searched (classification system followed by classification symbols)

C04B35/71-35/84; C23C16/00-16/56; C04B41/80-41/91

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 116003146 A (SHENZHEN LAPLACE ENERGY CO., LTD.) 25 April 2023 (2023-04-25) claim 1, paragraphs [0001], [0002], [0048]-[0081] | 1-4 |
| A | JP 2002-265285 A (JAPAN SCIENCE AND TECHNOLOGY CORPORATION) 18 September 2002 (2002-09-18) entire text | 1-4 |
| A | JP 2007-204362 A (UNITED TECHNOLOGIES CORPORATION) 16 August 2007 (2007-08-16) entire text | 1-4 |
| A | JP 8-198679 A (ISHIKAWAJIMA-HARIMA HEAVY INDUSTRIES CO., LTD.) 06 August 1996 (1996-08-06) entire text | 1-4 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **04 July 2024** | **30 July 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/017572**

| Patent document cited in search report | | | Publication date (day/month/year) | Patent family member(s) | | | Publication date (day/month/year) |
|---|---|---|---|---|---|---|---|
| CN | 116003146 | A | 25 April 2023 | (Family: none) | | | |
| JP | 2002-265285 | A | 18 September 2002 | WO | 2002/072502 | A1 | |
| JP | 2007-204362 | A | 16 August 2007 | US entire text EP KR | 2007/0172639 1815975 10-2007-0077116 | A1 A1 A | |
| JP | 8-198679 | A | 06 August 1996 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9821163 A1

- WO 2015129772 A1